# EUROPEAN PATENT APPLICATION

(11) **EP 1 840 946 A1**
(43) Date of publication of application: **03.10.2007**
(21) Application number: 05819632.0
(22) Date of filing: 22.12.2005
(51) Int. Cl.: H01L 21/205, H01L 21/3065, H01L 21/316

(54) **METHOD FOR CLEANING OF SEMICONDUCTOR PROCESSING APPARATUS AND METHOD FOR ETHCHING SILICON SUBSTRATE**

(30) Priority: 24.12.2004 JP 2004374107
(71) Applicant: Taiyo Nippon Sanso Corporation, Tokyo 142-8558 (JP)
(72) Inventor: ONO, Kouichi Kyoto University,Graduate School of Engineering,, Kyoto-shi, Kyoto (JP); KITAGAWA, T. Kyoto University, Graduate School of Engineering,, Kyoto-shi, Kyoto (JP); INOUE, Minoru Taiyo Nippon Sanso Corporation, Tokyo; 1428558 (JP); OOSAWA, Masanori Taiyo Nippon Sanso Corporation, Tokyo; 1428558 (JP)
(74) Representative: Smyth, Gyles Darren
(86) International application number: PCT/JP2005/023625
(87) International publication number: WO 2006/068235

(57) **Abstract**

A cleaning method for a processing chamber of semiconductor substrates is provided which is capable of rapidly removing deposits and accretions generated inside the chamber of processing semiconductor substrates of a high-dielectric-constant oxide and of preventing any reaction product depositing. The cleaning method for a processing chamber of semiconductor substrates includes activating a mixed gases which contains a halogenated gas and either an oxygen-contained gas or an oxidizing gas during a plasma treatment or a heating treatment in order to etch off the deposits or accretions.

## Description

### TECHNICAL FIELD

The present invention relates to a cleaning method for a processing chamber of semiconductor substrates by removing deposit or accretion of a high-dielectric-constant oxide formed inside a chamber of processing semiconductor substrates, and a etching method for a high-dielectric-constant oxide film formed on a silicon substrate.
Priority is claimed on Japanese Patent Application No. 2004-374107, filed December 24, 2004, the content of which is incorporated herein by reference.

### BACKGROUND ART

Hitherto, a silicon dioxide (SiO₂) and silicon oxynitride (SiON), has been widely used as a gate insulating film of a field effect transistors (FETs).
In order to enhance transistor performance and devise productivity, critical dimension of FETs has been shrunk. So, the thickness of gate insulating film is also reduced.

Presently, film thickness of a gate insulating film has become less than several nanometers, then the gate leak current, which caused standby-power consumption of the device, is increased. In order to solve this detrimental problem, attempts have been made to use a high-dielectric-constant oxide film which has a higher dielectric constant than conventional gate insulating films. Examples of insulating films made of a high-dielectric-constant oxide, which have been developed recently are insulating films which contain hafnium such as HfO_{z}, HfSiyO_{z}, HfAlyO_{z}, and HfSiAl_{y}O_{z}.

These high-dielectric-constant oxides are deposited on a substrate by a chemical vapor deposition method (CVD), or an atomic layer deposition method (ALD). This high-dielectric-constant oxide is preferably deposited onto only a substrate which is arranged at a predetermined position inside a deposition chamber. However, the high-dielectric-constant oxide film is deposited onto the inner wall of the chamber and in the vicinity of the substrate holder on which the substrate is placed.

As a result, there is possibility that the deposits or accretions may be peeled off suddenly when the film stress increased beyond the cohesiveness strength to the under layer, and dropped as particles to a substrate upon which a film is being formed, thereby causing defects of the products or failure of the chamber of processing semiconductor substrates.

In order to avoid these phenomena, it is necessary to clean off deposits at the inner wall or vicinity of the semiconductor substrate periodically. Mechanical or wet-chemical methods are known as methods for cleaning a chamber. However, mechanical or wet-chemical methods are not preferable, because there is a possibility that the surfaces of wall materials of the chamber may be damaged thereby, in addition to requiring labor and time.

Thus, it has been proposed to perform a chemical dry treatment for etch the deposited films consisted of a transition metal such as hafnium or a Group XIII metallic compound such as aluminum by a plasma treatment or a heating treatment using a chlorinated gas, without exposing the chamber to the atmospheric ambient (for example, refer to Patent document 1).

Patent document 1 discloses that desired cleaning cannot be performed if an excess of oxygen is added to the halogenated gas, because metal chloride will be converted into a metal oxide.

In addition, in a gate stack formation process, it is necessary to etch off a gate insulating film, of the high-dielectric-constant oxide on a source drain region of a transistor, by etching in order to form a contact after the gate stack has been formed. Since the thickness of a high-dielectric-constant oxide is not more than several nanometers, the etching speed will not be important, but the selectivity ratio of etching rate of high-dielectric-constant oxide film to that of a silicon substrate will be rather important.

Namely, a process with higher selectivity ratio of etching rates between a high-dielectric-constant oxide and a silicon substrate (high-dielectric-constant oxide: Si) more than 1 is required. Plasma etching using a halogenated gas has been attempted. However, a selectivity ratio of etching rates more than 1, has yet to be achieved.
[Patent document 1]
Japanese Unexamined Patent Application, First Publication No. 2004-146787

However, the cleaning method disclosed in Patent document 1 has the problem that the etching rate is quite low when performing thermal cleaning at only heating the inner wall of a chamber, and that the etching rate cannot be sufficiently increased when performing plasma treatment without applying a bias voltage or performing cleaning which comprises both plasma and thermal treatments.

In addition, Patent document 1 suggests performing cleaning in lower oxygen concentration conditions. However, the research of the inventors of the present invention has confirmed that, if cleaning is performed using pure BCl₃ gas, then the reaction product which contain B, Si, etc. will deposit inside the chamber, even though objective high-dielectric-constant oxide can be etched off. Thus, cleaning under a lower oxygen concentration conditions cannot be said to be optimal.

In addition, when a high-dielectric-constant oxide deposited on a silicon substrate is etched, as is mentioned above, there has been the problem that the selectivity ratio of etching rates between a high-dielectric-constant oxide and a silicon substrate has not exceeded 1. An etching method of a high-dielectric-constant oxide which etches a silicon substrate as little as possible is desired.

In light of the above problems, it is an object of the present invention to provide a cleaning method for a processing chamber of semiconductor substrates which can rapidly etch off deposits or accretions of a high-dielectric-constant oxide formed inside a processing chamber of semiconductor substrates, and prevent any reaction product depositing.

In addition, it is another object of the present invention to provide an etching method for a silicon substrate which can etch a high-dielectric-constant oxide film deposited onto a silicon substrate, at a high selectivity ratio of etching rates more than 1.

### DISCLOSURE OF THE INVENTION

In order to solve these problems, a first aspect of the present invention provides a new cleaning method for a chamber of processing semiconductor substrates to etch off deposits and accretions of a high-dielectric-constant oxide, which generated inside the chamber of processing semiconductor substrates by introducing activating mixed gases which contains a halogenated gas and either an oxygen-contained gas, which can be generated active oxygen atoms, or an oxidizing gas during a plasma treatment or by a heating treatment to etch off the deposits or accretions.

A second aspect of the present invention provides the cleaning method for a chamber of processing semiconductor substrates as set forth in the first aspect of the present invention, in which the halogenated gas is one or more kinds of gas selected from the group of BCl₃, HCl, Cl₂, SiCl₄, HBr, BBr₃, SiBr₄ and Br₂.

A third aspect of the present invention provides the cleaning method for a chamber of processing semiconductor substrates as set forth in the first aspect or the second aspect of the present invention, in which the oxygen-contained gas, which can be generated active oxygen atoms is one or more kinds of gas selected from the group of O₂, O₃, H₂O, H₂O₂, COₓ, SOₓ and NOₓ (x is an integer more than or equal to 1).

A fourth aspect of the present invention provides any one of the first aspect to the third aspect of the present invention, in which the oxidizing gas is NF₃ and/or N₂O.

A fifth aspect of the present invention provides any one of the first aspect to the fourth aspect of the present invention, in which the high-dielectric-constant oxide is one or more kinds of oxide selected from the group of HfO_{z}, ZrO_{z}, AlyO_{z}, HfSi_{y}O_{z}, HfAl_{y}O_{z}, ZrSi_{y}O_{z} and ZrAl_{y}O_{z} (each of y and z is an integer or decimal number more than 0).

A sixth aspect of the present invention provides the fifth aspect of the present invention, in which the high-dielectric-constant oxide film further contains nitrogen atoms.

A seventh aspect of the present invention provides any one of the first aspect to the sixth aspect of the present invention, in which the mixed gases which contains a halogenated gas and either an oxygen-contained gas, which can be generated active oxygen atoms or an oxidizing gas further contains a fluorinated gas.

An eighth aspect of the present invention provides the seventh aspect of the present invention, in which the fluorinated gas is one or more kinds of gas selected from the group of CF₄, C₂F₆, C₃F₈, C₄F₆, ClF₃, F₂, SF₆, and COF₂.

A ninth aspect of the present invention provides any one of the first aspect to the eighth aspect of the present invention, in which the chamber of processing semiconductor substrates is an apparatus used in any one of a chemical vapor deposition (CVD) method and an atomic layer deposition (ALD) method, or an etching apparatus for etching a high-dielectric-constant oxide film.

A tenth aspect of the present invention provides a method for etching a high-dielectric-constant oxide film deposited on a silicon substrate, including activating a mixed gases which contains a halogenated gas and either an oxygen-contained gas, which can be generated active oxygen atoms, or an oxidizing gas during a plasma treatment or a heating treatment to etch the high-dielectric-constant oxide film.

By using a cleaning method of the present invention, deposits or accretions of a high-dielectric-constant oxide formed inside a chamber of processing semiconductor substrates can be rapidly etched off, and deposits of reaction product can be prevented by a mixed gases which contains a halogenated gas and either an oxygen-contained gas, which can be generated active oxygen atoms, or an oxidizing gas.

In addition, by using a etching method of the present invention, a high-dielectric-constant oxide deposited onto a silicon substrate can be etched without applying bias voltage, at a high selectivity ratio of etching rates of more than 1, by a mixed gases which contains a halogenated gas and either an oxygen-contained gas, which can be generated active oxygen atoms or an oxidizing gas.

### BRIEF DESCRIPTION OF THE DRAWINGS

FIG. 1 is a schematic view showing a microwave plasma etching apparatus which is an example of a chamber of processing semiconductor substrates of the present invention.
FIG. 2 is a graph showing the relation between the etching rate of HfO₂ film and the mixture ratio of oxygen in the total gases.
FIG 3 is a graph showing the relation between the etching rate of HfO₂ film and the chamber pressure for different mixture ratio of oxygen in the total gases.
FIG. 4 is a graph showing the relation between the chamber pressure and etching rates of HfO₂ film and silicon substrate.

BEST MODE FOR CARRYING OUT THE INVENTION

### [Cleaning method]

A cleaning method of a chamber of processing semiconductor substrates of the present invention etches off deposits or accretions of a high-dielectric-constant oxide.

Examples of such a high-dielectric-constant oxide are hafnium oxide, aluminum oxide and zirconium oxide, such as HfO_{z}, ZrO_{z}, Al_{y}O_{z}, HfAlyO_{z}, HfSiAlyO_{z}, ZrSi_{y}O_{z}, ZrAl_{y}O_{z} (both of y and z are integers greater than 0 or decimal numbers), aluminum, and zirconium. In these oxides, one or more of kinds of oxide selected from the group of HfO_{z}, ZrO_{z}, AlyO_{z}, HfSiyO_{z}, HfAlyO_{z}, ZrSiyO_{z}, ZrAlyO_{z} (both of y and y z are integers more than 0 or decimal numbers) is preferable.
The compositions of high-dielectric-constant oxides are not limited to be stoicheiometric or no-stoicheiometric.

In addition, the high-dielectric-constant oxide film may further contain nitrogen atoms. For example, HfO_{b}N_{c}, HfSiₐO_{b}N_{c}, and HfAlₐO_{b}N_{c} (a, b and c are integer numbers more than 0 or decimal numbers), etc. are typical candidates.

A deposit or an accretion formed inside a cleaning chamber of processing semiconductor substrates contains these high-dielectric-constant oxides, and may further contain Si or C.

In addition, a cleaning method for a chamber of processing semiconductor substrates of the present invention etches off deposits or accretions of a high-dielectric-constant oxide, and being generating inside the chamber of processing semiconductor substrates, by activating a mixed gases which contains a halogenated gas and either an oxygen-contained gas, which can be generated active oxygen atoms or an oxidizing gas during a plasma treatment or a heating treatment.

As a halogenated gas, which be well known to make the high-dielectric-constant oxides into volatile compounds, one or more selected from the group of BCl₃, HCl, Cl₂, SiCl₄, HBr, BBr₃, SiBr₄, and Br₂ is preferable. In these gases, BCl₃ is preferable, because BCl₃ has a reductive effect or a propensity to extract oxygen. By a halogenated gas, deposits or accretions of the high-dielectric-constant oxide can be converted into a halogenide (HfCl₄, HfBr₄, AlCl₃, AlBr₃, ZrCl₄, ZrBr₄, SiCl₄, SiBr₄, etc.). Since these halogenides are so volatile, the halogenides can be easily etched off and exhausted out of a chamber.

In addition, as an oxygen-contained gas, which can be generated active oxygen atoms, one or more selected from the group of O₂, O₃, H₂O, H₂O₂, COₓ, SOₓ and NOₓ (x is an integer more than or equal to 1) is preferable. Out of these gases, O₂ is preferable, because O₂ is more likely to generate an oxygen radical. In addition, NF₃ and/or N₂O are preferable as an oxidizing gas.

In the present invention, the mixed gases obtained by mixing a halogenated gas with either an oxygen-contained gas, which can be generated active oxygen atoms or an oxidizing gas is used. With respect to the mixing rate, the oxygen-contained gas, which can be generated active oxygen atoms or the oxidizing gas is preferably added ranging from 1 to 50% of the total gases. In addition, the resultant mixed gases may be distilled with a rare gas such as argon or helium and used.

An oxygen-contained gas, which can be generated active oxygen atoms, having an oxidizing effect or an oxidizing gas is mixed into a halogenated gas which is a typical one as a cleaning gas in order to prepare mixed gases and used, thereby easily removing deposits or accretions of a high-dielectric-constant oxide, and preventing any reaction product which contains B, Si, etc. depositing inside a chamber.

In addition, it is preferable to add a fluorinated gas to the mixed gases. By further adding a fluorinated gas to the mixed gases, the cleaning of deposits or accretions of a high-dielectric-constant oxide which contains Si can be performed more efficient. As such a fluorinated gas, one or more selected from the group of CF₄, C₂F₆, C₃F₈, C₄F₆, ClF₃, F₂, SF₆, and COF₂ is more preferable. In addition, the mixing ratio of fluorinated preferably ranges from 1 to 50% of the total gases.

As a method for activating the mixed gases, the mixed gases can be excited by performing a plasma discharge using a radio frequency source (RF) or a microwave source before introducing into a chamber of processing semiconductor substrates. In addition, the mixed gases may be excited by forming plasma discharge inside a chamber or the mixed gases may be excited by heating. Plasma discharge can be generated by means which are commonly used such as electron cyclotron resonance (ECR), inductively coupled plasma (ICP), helicon wave excited plasma (HWP), transformer coupled plasma (TCP), surface wave plasma (SWP), capacitively coupled plasma (CCP).

In addition, the chamber of processing semiconductor substrates of the present invention concerns a high-dielectric-constant oxide, and concerns preferably an apparatus which is used in either a chemical vapor deposition (CVD) method or an atomic layer deposition (ALD) method or an etching method which etches a high-dielectric-constant oxide. Chemical Vapor Deposition method forms a thin film using a chemical reaction in a gas phase at relative high temperature. Specifically, after chamber of processing semiconductor substrates is evacuated, a silicon substrate is placed on a substrate holder, and then the substrate is heated at a temperature ranging from 450 to 600°C using a heater. Thereafter, a mixed gases of Ar, O₂, and Hf source gas such as Hf(DPM)₄, and Hf(MMP)₄ is introduced into a chamber, and a high-dielectric-constant oxide such as HfO₂ of a thickness ranging from 2 to 3 nm is deposited onto the silicon substrate. Chamber pressure is adjusted by a gate valve during deposition process so as to be a predetermined value.

In addition, Atomic Layer Deposition method forms a film of high quality and high step coverage, by repeating adsorption and evacuation of a source compound for every layer onto a surface of a substrate, forming a film by a reaction, and resetting the conditions inside the chamber. In particular, at this method, the substrate temperature is ranging from 100 to 350°C, so slightly lower than at a conventional hot-CVD method ranging from 350 to 500°C. A metallorganic compound (for example, [(CH₃)₂N]₄Hf, a chloride type HfCl₄ etc.) is used as a source gas and, water (H₂O) are alternately supplied into a chamber, and a film of monolayer is formed.

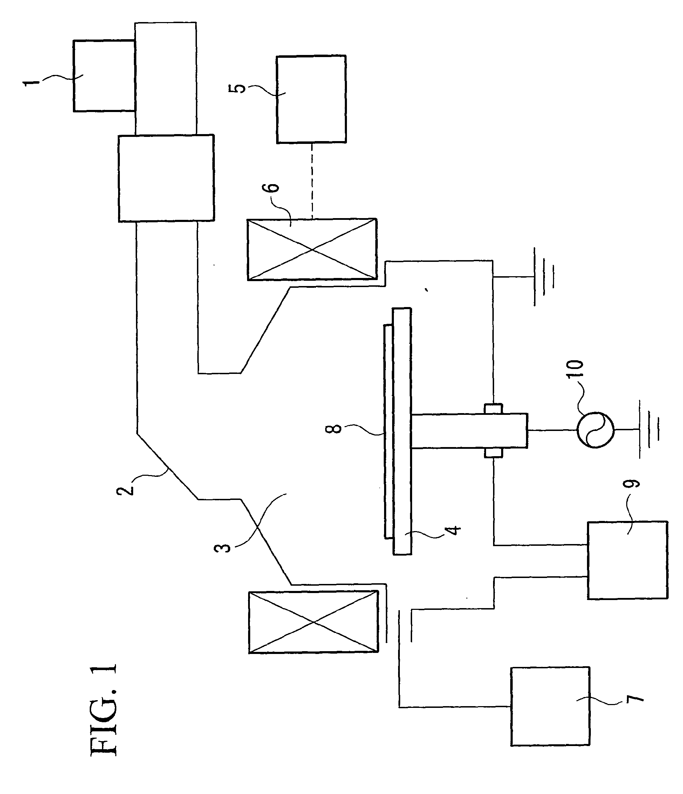

FIG. 1 is a schematic view which shows an ECR etching apparatus which is an example of a chamber of processing semiconductor substrates of the present invention. This chamber of processing semiconductor substrates is constituted from a magnetron 1 which emits microwaves of 2.45GHz, a waveguide 2 which guides emitted microwaves to a chamber 3, a chamber 3 in which cleaning or etching is performed, a gas supplying unit 7 which supplies a source gas, i.e. a cleaning gas, or an etching gas, a vacuum pumping exhausting unit 9 which exhausts gas, and a solenoid coil 6 installed outside the chamber in order 3 to generate a magnetic field. This chamber of processing semiconductor substrates is constructed such that both cleaning and etching can be conducted.

Chamber 3 accommodates a lower electrode 4 onto which a silicon substrate 8 with a deposited high-dielectric-constant oxide. Normally, in these experiments described in this patent a radio frequency source 10 is not connected to lower electrode 4. In addition, a magnetic-field-generating DC source 5 which supplies a direct current is connected to the solenoid coil 6.

Microwaves having a frequency of 2.45 GH_{z} emitted from the magnetron 1 is propagate through the waveguide 2 to be introduced into the chamber 3. When a direct current is supplied from the magnetic-field-generating DC source 5 to the solenoid coil 6 disposed outside the chamber, the cleaning gas or etching gas supplied from the gas supplying unit 7 is converted into plasma by a magnetic field of 875 G and microwave electric field generated inside the chamber 3. Cleaning of deposit or accretion consisting of a high-dielectric-constant oxide formed inside the chamber 3, or etching of a high-dielectric-constant oxide deposited layered onto the silicon substrate 8 can be performed by this gas converted into plasma.

Specifically, the chamber 3 is evacuated to a vacuum, and then mixed gases of a halogenated gas and either an oxygen-contained gas, which can be generated active oxygen atoms, or an oxidizing gas is introduced into the chamber 3. The chamber pressure preferably ranges from 0.5 to 2 Pa (from 3.8 to 15 mTorr). In this condition, the flow rate of the mixed gases preferably ranges from 10 to 50 sccm. Subsequently, plasma is discharged at a microwaves power of 600 W and current of 240 mA is applied to the magnetron 1 to emit microwaves, thereby generating plasma. In the case without DC bias to the lower electrode 4, etching of HfO₂ film is performed no electrical power is supplied from the high frequency source 10 to the mounting. In this condition, the temperatures of the lower electrode 4 and of the inner wall of the chamber 3 preferably range from room temperature to 350 °C.

By a cleaning method of the present invention, deposits or accretions of a high-dielectric-constant oxide formed inside a chamber of processing semiconductor substrates can be rapidly etched off, and deposits of reaction product can be prevented by a mixed gases which contains a halogenated gas and either an oxygen-contained gas, which can be generated active oxygen atoms, or an oxidizing gas. In addition, because the cleaning rate increases, the cleaning time can be shortened, and production efficiency can be improved.

In addition, as an example, an apparatus of a Chemical Vapor Deposition (CVD) method, and an Atomic Layer Deposition (ALD) method has been described. However, it is possible to etch off a high-dielectric-constant oxide which has been deposited or has accumulated inside an etching apparatus which etches a high-dielectric-constant oxide through the cleaning method similar to these deposition apparatus.

### [Etching Method]

The etching method of the present invention provides a process for etching a high-dielectric-constant oxide film deposited on a silicon substrate, including activating mixed gases which contains a halogenated gas and either an oxygen-contained gas, which can be generated active oxygen atoms, or an oxidizing gas during a plasma treatment or a heating treatment.

Since the high-dielectric-constant oxide, the mixed gases, the plasma treatment, the heating treatment, and the chamber of processing semiconductor substrates in which the treatments are performed are the same as those in the cleaning method, explanations are omitted. The difference with the cleaning method is that the objective of etching is a high-dielectric-constant oxide film deposited on a silicon substrate.

In addition, in general, in the case in which etching is performed, a bias voltage is applied to a lower electrode on which a substrate is placed in order to accelerate ions generated by plasma, thereby directing the ions in a perpendicular direction and hitting the ions onto the substrate. This is a difference from the cleaning method. However, it is not necessary to apply bias voltage during the etching process of the present invention. The high-dielectric-constant oxide film deposited onto a silicon substrate can be rapidly etched, without applying bias voltage by mixed gases which contains a halogenated gas and either an oxygen-contained gas, which can be generated active oxygen atoms, or an oxidizing gas.

The specific etching method, it can be performed in the same manner as the cleaning method described earlier. During the etching process, the etching rate of the high-dielectric-constant oxide film can be further increased by heating the silicon substrate at a temperature ranging from 250 to 300°C.

In addition, in the method for etching of the present invention, only a high-dielectric-constant oxide is etched selectively, whereas a silicon substrate is not etched. And as a result, the selectivity ratio of etching rates between the high-dielectric-constant oxide and the silicon substrate is much more than 1. With this etching method of the present invention, it is possible to etch without damage to a silicon substrate.

### EXAMPLE

The present invention will be explained in more detail below by way of Examples. It should be noted that the present invention is not limited at all by the following Examples.

### [Example 1]

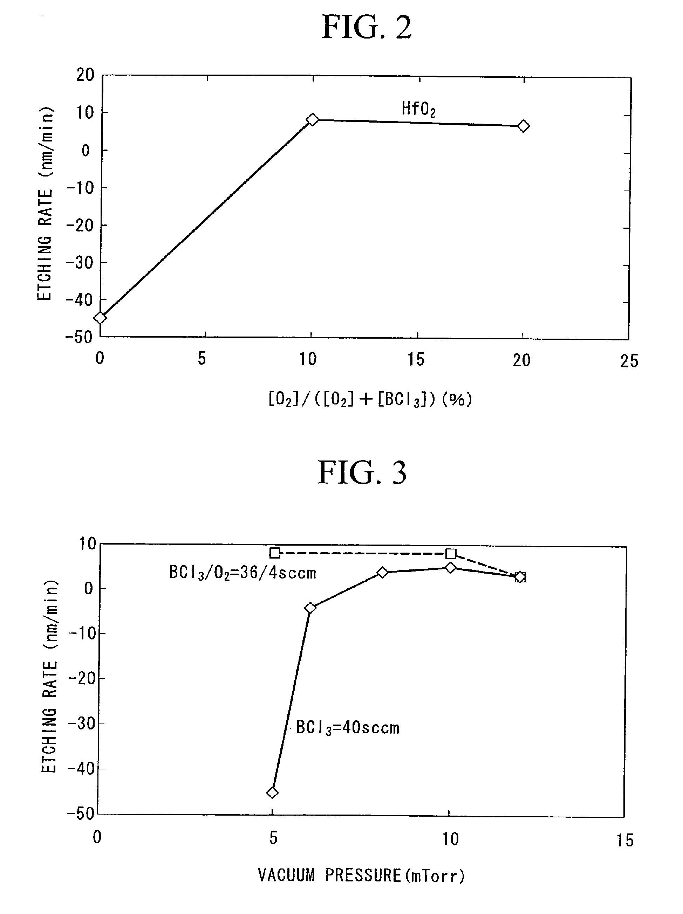

Using a chamber of processing semiconductor substrates shown in FIG. 1, a HfO₂ film of 100 nm thick deposited on a silicon substrate was etched. Microwaves of 2.45 GHz and a magnetic field of 875 G were used to generate ECR plasma condition. A silicon substrate was exposed to plasma without DC bias from a radio frequency source connecting to a lower electrode. As an etching gas, a mixed gas of BCl₃ and O₂ was used, and the mixture ratio of oxygen was varied from 0% to 20%. The etching conditions are shown in Table 1. The change in film thickness of HfO₂ film was measured before and after the exposure to plasma. The correlation between the mixture ratio of oxygen and the etching rate of HfO₂ film when the added amount of oxygen in the mixed gas was varied is shown in FIG. 2.

**[Table 1]**

| | Cleaning conditions |
|---|---|
| Microwaves power and current | 600 W, 200 mA |
| Radio frequency power of lower electrode | 0 W(Floating) |
| chamber pressure | 0.67 Pa (5 mTorr) |
| O₂ + BCl₃ total flow rate | 40 sccm |
| Temperature of lower electrode and chamber wall | Room temperature |

From the results shown in FIG. 2, in the case in which pure BCl₃ gas introduced without oxygen, no etching occurred, and a deposit was observed which seems to be derived from the etching gas. On the other hand, in the case in which the mixture ratio of oxygen was 10% or 20%, no deposits were generated, and the etching was confirmed to have been performed at a desirable rate.

### [Example 2]

Etching was performed in the same way as in example 1, with the exception that the mixture ratio of oxygen in the mixed gas is set to be 0% or 10% and the chamber pressure is varied from 5 to 12 mTorr. The change in thickness of HfO₂ film was measured to obtain the etching rate. The etching conditions are shown in Table 2. The correlation between the chamber pressure and the etching rate of HfO₂ film with different amounts of oxygen is shown in FIG. 3.

**[TABLE2]**

| | |
|---|---|
| Microwaves power and current | 600 W, 240 mA |
| Radio frequency power of lower electrode | 0 W(Floating) |
| chamber pressure | 0.67 to 1.6Pa (5 to 12 mTorr) |
| Etching gas | BCl₃/O₂ = 3 6/4 sccm, BCl₃ = 40 sccm |
| Temperature of lower electrode and chamber wall | Room temperature |

From the results shown in FIG 3, in the case in which pure BCl₃ gas introduced without oxygen (solid line), deposits were observed at the chamber pressure of 5 mTorr and 6 mTorr, and etching was observed when the chamber pressure was more than 8 mTorr. However, in the case in which the mixture ratio of oxygen was 10% (dotted line), no deposits were observed, and in the case in which the chamber pressure was lower than 10 mTorr, the etching rate was confirmed to be larger than that of the pure BCl₃ case.

### [Example 3]

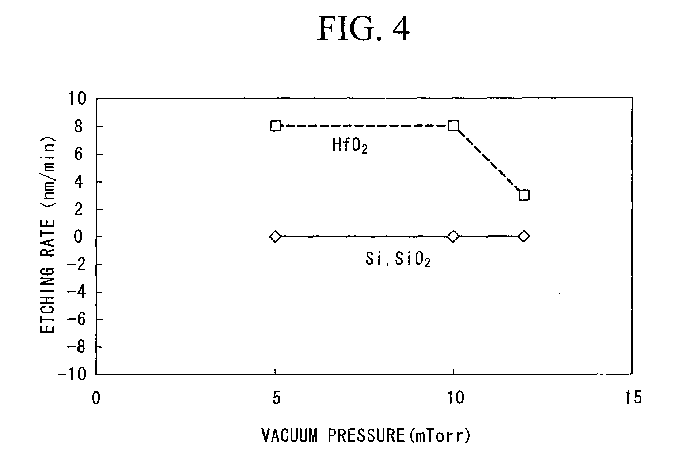

Etching was performed in the same way as in example 2, with the exception that the mixture ratio of oxygen was set to be 10% and the chamber pressure was varied from 5 to 12 mTorr. The change in thickness between HfO₂ film and a silicon substrate was measured to obtain the etching rate. The correlation between the chamber pressure and the etching rate of HfO₂ film when the chamber pressure was varied is shown in FIG 4.

From the results shown in FIG. 4, no etching of the silicon substrate was observed and no deposits were present. The HfO₂ film was etched at a desirable etching rate, and no deposits were observed. The selective ratio in this case was more than 1.

From the results above, it is confirmed that, by using the etching method of the present invention, a high-dielectric-constant oxide film deposited onto a silicon substrate can be etched with a high selectivity ratio of etching rates of more than 1, without applying bias voltage, by a mixed gases which contains a halogenated gas and either an oxygen-contained gas, which can be generated active oxygen atoms, or an oxidizing gas.

### INDUSTRIAL APPLICABILITY

The present invention can be applied to the cleaning method of a chamber of processing semiconductor substrates which can rapidly etch off deposits or accretions of a high-dielectric-constant oxide generated inside a chamber of processing semiconductor substrates and prevent any reaction product depositing of.

## Claims

1. A cleaning method for a processing chamber of semiconductor substrates to etch off deposits or accretions generated inside the chamber of processing semiconductor substrates of a high-dielectric-constant oxide, comprising activating a mixed gases which contains a halogenated gas and either an oxygen-contained gas, which can be generated active oxygen atoms, or an oxidizing gas during a plasma treatment or a heating treatment in order to etch off the deposits or accretions.

2. The cleaning method for a chamber of processing semiconductor substrates as set forth in claim 1, wherein the halogenated gas is one or more kinds of gas selected from the group of BCl₃, HCl, Cl₂, SiCl₄, HBr, BBr₃, SiBr₄ and Br₂.

3. The cleaning method for a chamber of processing semiconductor substrates as set forth in claim 1 or 2, wherein the oxygen-contained gas, which can be generated active oxygen atoms, is one or more kinds of gas selected from the group of O₂, O₃, H₂O, H₂O₂, COₓ, SOₓ and NOₓ (x is an integer number more than 0 or equal to 1).

4. The cleaning method for a chamber of processing semiconductor substrates as set forth in claim 1 or 2, wherein the oxidizing gas is NF₃ and/or N₂O.

5. The cleaning method for a chamber of processing semiconductor substrates as set forth in claim 1 or 2, wherein the high-dielectric-constant oxide is one or more kinds of oxide selected from the group of HfO_{z}, ZrO_{z}, AlyO_{z}, HfSiyO_{z}, HfAl_{y}O_{z}, ZrSi_{y}O_{z} and ZrAl_{y}O_{z} (each of y and z is an integer more than 0 or decimal number).

6. The cleaning method for a chamber of processing semiconductor substrates as set forth in claim 1 to 5, wherein the high-dielectric-constant oxide film further contains nitrogen atoms.

7. The cleaning method for a chamber of processing semiconductor substrates as set forth in claim 1 or 2, wherein the mixed gases which contains the halogenated gas and either the oxygen-contained gas, which can be generated active oxygen atoms, or the oxidizing gas further contains a fluorinated gas.

8. The cleaning method for a chamber of processing semiconductor substrates as set forth in claim 7, wherein the fluorinated gas is one or more kinds of gas selected from the group consisting of CF₄, C₂F₆, C₃F₈, C₄F₆, ClF₃, F₂, SF₆, and COF₂.

9. The cleaning method for a chamber of processing semiconductor substrates as set forth in claim 1 or 2, wherein the chamber of processing semiconductor substrates is an apparatus used in any one of a cleaning method of a chemical vapor deposition (CVD) method and an atomic layer deposition (ALD) method, or is an etching apparatus for etching a high-dielectric-constant oxide film.

10. A etching method for a high-dielectric-constant oxide film deposited on a silicon substrate, comprising activating a mixed gases which contains a halogenated gas and either an oxygen-contained gas, which can be generated active oxygen atoms, or an oxidizing gas during a plasma treatment or a heating treatment in order to etch the high-dielectric-constant oxide film.
